# FASCICULE DE BREVET EUROPEEN

(11) **EP 2 448 390 B1**
(45) Date de publication et mention de la délivrance du brevet: **19.03.2014**
(21) Numéro de dépôt: 11186085.4
(22) Date de dépôt: 21.10.2011
(51) Int. Cl.: H05K 7/14

(54) **Carte électronique de fond de panier d'un équipement électronique, notamment pour aéronef**
Elektronikkarte eines elektronischen Gerätes mit Rückwandplatine, insbesondere für ein Flugzeug
Backplane electronic board of an electronic device, in particular for an aircraft

(30) Priorité: 28.10.2010 FR 1058881
(43) Date de publication de la demande: 02.05.2012
(73) Titulaire: Airbus Operations, 31060 Toulouse (FR)
(72) Inventeur: Caron, Jean-Christophe, 31490 LEGUEVIN (FR); Rebeyrotte, Vincent, 31770 COLOMIERS (FR)
(74) Mandataire: Stankoff, Hélène

(56) Documents cités:
- FR-A1- 2 917 905
- US-A- 5 348 482
- US-A1- 2002 180 554
- US-B1- 6 362 968

## Description

La présente invention concerne une carte électronique de fond de panier d'un équipement électronique.

De manière générale, la présente invention concerne le renforcement d'un équipement électronique, notamment embarqué dans un aéronef, et ainsi soumis à des contraintes vibratoires importantes.

Plus généralement, la présente invention concerne la protection des équipements électroniques embarqués, qui sont soumis à des contraintes vibratoires importantes lors de leur utilisation.

En particulier, dans un aéronef, les équipements électroniques sont exposés à des vibrations et voient ainsi leur fiabilité réduite au cours du temps.

Dans certain cas extrême, les vibrations peuvent même conduire à une perte irrémédiable de certaines fonctions électriques de l'équipement électronique.

De manière générale, un équipement électronique comporte une carte électronique de fond de panier, montée mécaniquement sur un socle, à laquelle vient se connecter un ensemble de cartes électroniques.

La carte électronique de fond de panier comporte généralement un connecteur d'interface avec un système externe à l'équipement électronique.

Dans une application aéronef, ce connecteur d'interface est adapté à connecter l'équipement électronique avec les moyens électriques de l'aéronef.

La carte électronique de fond de panier comporte également deux cartes d'interface connectées l'une à l'autre, une première carte d'interface étant reliée au connecteur d'interface et une seconde carte d'interface étant destinée à la connexion de l'ensemble des cartes électroniques de l'équipement électronique.

Sous l'effet des vibrations engendrées lors du fonctionnement de l'aéronef, l'ensemble de l'équipement électronique est amené à se déformer.

Notamment, la carte électronique de fond de panier est particulièrement sensible aux phénomènes vibratoires dès lors qu'ils entraînent une fatigue importante au niveau des interfaces et des connexions, notamment des connexions entre le connecteur d'interface et la première carte d'interface, mais également les connexions des composants montés sur la carte électronique de fond de panier.

En particulier, les vibrations peuvent entraîner des dégradations mécaniques par frottement au niveau des contacts dans les zones d'interface du connecteur d'interface et des cartes d'interface.

Ces dégradations mécaniques peuvent aller jusqu'à la rupture de certaines broches de connexion, détruisant ainsi des fonctionnalités de la carte électronique de fond de panier.

On connaît ainsi le document FR 2 917 905 qui décrit un équipement avionique comportant une carte mère et au moins une carte fille qui présente deux supports en forme de glissière fixés sur la carte mère.

On connaît aussi le document US 5 348 482 qui concerne un boitier pour un équipement de fond de panier comprenant plusieurs cartes filles.

On connait enfin dans le document FR 2 848 773 la mise en place d'une structure haubanée pour limiter les effets des vibrations sur la tenue des composants électroniques et sur la connectique de cartes électroniques de grandes dimensions.

Ce document propose ainsi de disposer sur chaque face de cartes électroniques des structures haubanées, permettant de réduire les effets mécaniques des vibrations.

Ces structures haubanées nécessitent toutefois une mise sous tension mécanique afin de placer la carte électronique sous contrainte mécanique.

Elles compliquent ainsi le montage de l'équipement électronique et augmentent l'encombrement des cartes électroniques elles-mêmes.

Par ailleurs, ces structures haubanées sont limitées aux cartes électroniques de l'équipement électronique, et ne permettent pas la protection de la carte électronique de fond de panier sur laquelle les nombreuses zones d'interface et de connexion sont particulièrement sensibles aux vibrations auxquelles est soumis l'équipement électronique embarqué dans l'aéronef.

La présente invention propose une solution pour retarder la fatigue mécanique liée aux vibrations et augmenter ainsi la fiabilité d'un équipement électronique en minimisant les déplacements relatifs des différents éléments constituant la carte électronique de fond de panier de cet équipement électronique.

A cet effet, la présente invention concerne une carte électronique de fond de panier d'un équipement électronique embarqué comportant un connecteur d'interface avec un système externe et deux cartes d'interface connectées l'une à l'autre, une première carte d'interface étant reliée audit connecteur d'interface et une seconde carte d'interface étant destinée à la connexion d'un ensemble de cartes électroniques dudit équipement électronique, la carte électronique de fond de panier comportant des moyens de renfort montés entre lesdites deux cartes d'interface.

Selon l'invention, les moyens de renfort comprennent des raidisseurs s'étendant selon un axe longitudinal parallèle au plan desdites deux cartes d'interface et formant entretoises entre deux faces disposées en vis-à-vis desdites deux cartes d'interface.

Ainsi, en montant des moyens de renfort dans l'espace existant entre les deux cartes d'interface de la carte électronique de fond de panier, il est possible de limiter la déformation relative de ces cartes d'interface et de protéger ainsi les connexions existantes.

Par ailleurs, les moyens de renfort s'insérant dans l'encombrement existant, leur montage n'engendre pas de modifications de la carte électronique de fond de panier, ni de l'équipement électronique lui-même et le temps de montage et de positionnement des moyens de renfort est négligeable dès lors que ces moyens de renfort sont montés entre les deux cartes d'interface au moment de leur connexion l'une à l'autre.

Grâce à l'utilisation de raidisseurs allongés, il est possible de maintenir grâce à ces entretoises l'espacement entre les deux faces disposées en vis-à-vis des cartes d'interface et de limiter ainsi les déformations relatives de ces deux cartes d'interface, évitant ainsi une usure prématurée des broches de connexion.

En pratique, les moyens de renfort comprennent des premiers moyens de renfort comprenant un cadre disposé en vis-à-vis de la périphérie du connecteur d'interface.

Les déplacements relatifs des contacts au niveau du connecteur d'interface connecté à la première carte d'interface de la carte électronique de fond de panier sont ainsi fortement réduits et l'usure mécanique est ainsi atténuée.

Les premiers moyens de renfort permettent ainsi de limiter les dégradations mécaniques par frottement des contacts du connecteur d'interface.

Par ailleurs, les moyens de renfort comprennent des seconds moyens de renfort disposés entre deux bords libres en vis-à-vis des deux cartes d'interface.

Le positionnement de ces seconds moyens de renfort au niveau des bords libres des cartes d'interface permet d'atténuer la déformation des cartes d'interface et de protéger ainsi les composants et leur connexion sur ces cartes d'interface.

Ces seconds moyens de renfort permettent ainsi d'améliorer la tenue des composants sur les cartes d'interface.

Selon un second aspect, la présente invention concerne un équipement électronique embarqué, notamment équipement avionique, comprenant une carte électronique de fond de panier conforme à l'invention.

Cet équipement électronique embarqué présente des caractéristiques et avantages analogues à ceux décrits précédemment.

Selon une caractéristique de réalisation, la carte électronique de fond de panier est montée dans un socle de l'équipement électronique embarqué, lesdits moyens de renfort comprenant des pieds de fixation montés sur le socle de l'équipement électronique.

Ainsi, les pieds de fixation permettent une reprise mécanique sur le socle de l'équipement électronique des efforts supportés par les moyens de renfort montés sur la carte électronique de fond de panier, garantissant ainsi la raideur de l'équipement électronique embarqué.

Finalement, selon un troisième aspect, la présente invention concerne un aéronef comprenant un ou plusieurs équipements électroniques embarqués conforme à l'invention.

Cet aéronef présente des caractéristiques et avantages analogues à ceux décrits précédemment en relation avec l'équipement électronique embarqué.

D'autres particularités et avantages de l'invention apparaîtront encore dans la description ci-après.

Aux dessins annexés, donnés à titre d'exemples non limitatifs:
- la figure 1 est une vue en perspective d'un équipement électronique conforme à un mode de réalisation de l'invention, un capot de protection ayant été ôté ;
- la figure 2 est une vue analogue à la figure 1 dans laquelle les deux cartes d'interface et les moyens de renfort ont été ôtés ;
- la figure 3 est une vue en perspective des deux cartes d'interface de l'équipement de la figure 1, et des moyens de renfort montés entre celles-ci ;
- la figure 4 est une vue analogue à la figure 3, dans laquelle une première carte d'interface a été ôtée ;
- la figure 5 est une vue en perspective illustrant des premiers moyens de renfort ;
- la figure 6 est une vue en perspective illustrant des seconds moyens de renfort ; et
- la figure 7 est une vue schématique symbolisant le montage des premiers moyens de renfort en vis-à-vis du connecteur d'interface de la carte électronique de fond de panier de la figure 1.

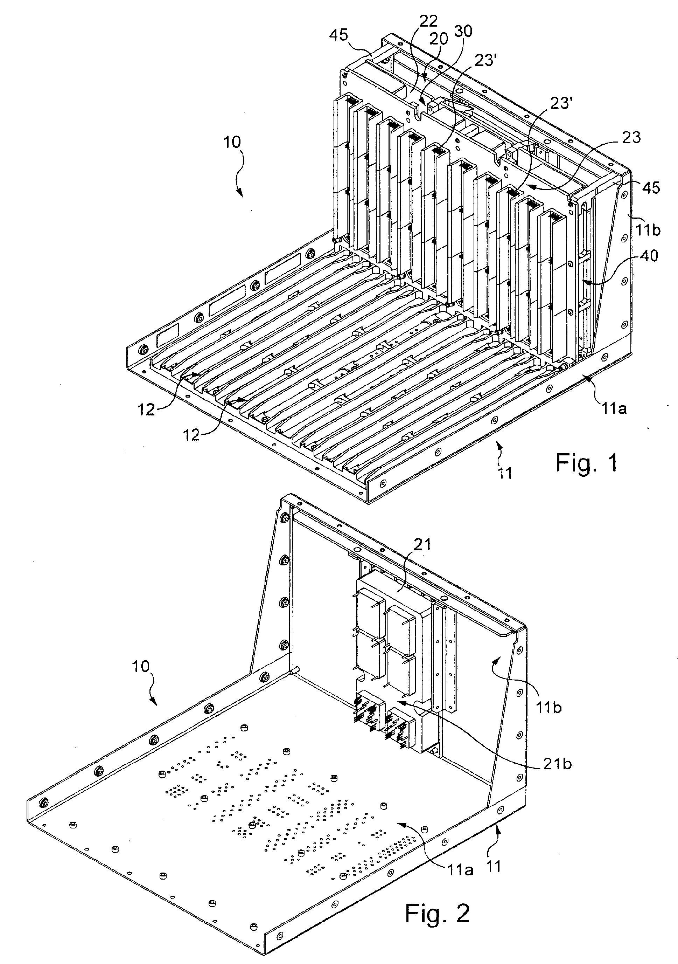

On va décrire tout d'abord en référence à la figure 1 un équipement électronique conforme à un mode de réalisation de l'invention.

L'équipement électronique 10 est destiné à être embarqué dans un véhicule, et notamment dans un aéronef.

Un tel équipement électronique possède globalement une forme parallélépipédique et est constitué d'un socle 11 fermé d'un capot (non représenté).

Comme bien illustré également à la figure 2, le socle 11 de l'équipement électronique 10 comporte une première partie constituant la base 11 a du socle 11, représentée horizontalement sur les figures 1 et 2 et une seconde partie, représentée verticalement aux figures 1 et 2, et constituant le fond 11 b du socle 11 de l'équipement électronique 10.

Le fond 11 b du socle 11 est ainsi monté en équerre avec la base 11a du socle 11.

Le capot de protection (non représenté) peut être placé au-dessus de ce socle de manière à fermer la face supérieure, parallèle à la base 11 a, et les faces latérales, s'étendant dans un plan perpendiculaire à la base 11a et au fond 11 b du socle 11.

La face avant, opposée au fond 11 b de l'équipement électronique, peut être ouverte ou fermée par un couvercle (non représenté).

Sur le fond 11b du socle 11 est montée une carte électronique de fond de panier 20 qui sera décrite en détail ultérieurement.

Cette carte électronique de fond de panier est destinée notamment à constituer l'interface entre l'équipement électronique 10 et son environnement, et notamment dans cette application, le système avionique.

La base 11a du socle 11 comporte également dans ce mode de réalisation un certain nombre de rainures 12 adaptées au logement respectivement d'un ensemble de cartes électroniques de l'équipement électronique, destinées à être connectées à la carte électronique de fond de panier 20.

Le montage d'un ensemble de cartes électroniques dans un équipement électronique et leur connexion à une carte électronique de fond de panier sont bien connus de l'homme du métier et n'ont pas besoin d'être décrits plus en détail ici.

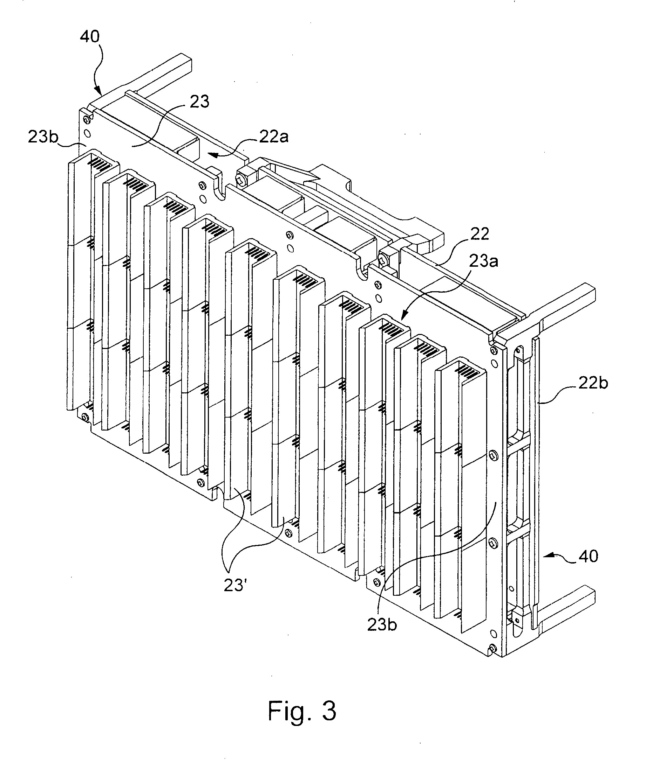

On va décrire à présent en référence aux figures 2 et 3 une carte électronique de fond de panier conforme à un mode de réalisation de l'invention.

Cette carte électronique de fond de panier 20 comporte tout d'abord un connecteur d'interface 21 permettant de connecter l'équipement électronique avec un système externe électrique et mécanique.

Comme bien illustré à la figure 2, ce connecteur d'interface 21 comporte une première face (non visible) destinée à être montée dans le fond 11 b du socle 11 et à déboucher ainsi sur la face externe du fond 11 b de l'équipement électronique pour permettre, de manière connue, la connexion de l'équipement électronique au système externe.

Par ailleurs, le connecteur d'interface 21 comprend une seconde face 21 b munie d'un ensemble de contacts destinés à relier ce connecteur d'interface 21 à une première carte d'interface 22 telle qu'illustrée à la figure 3.

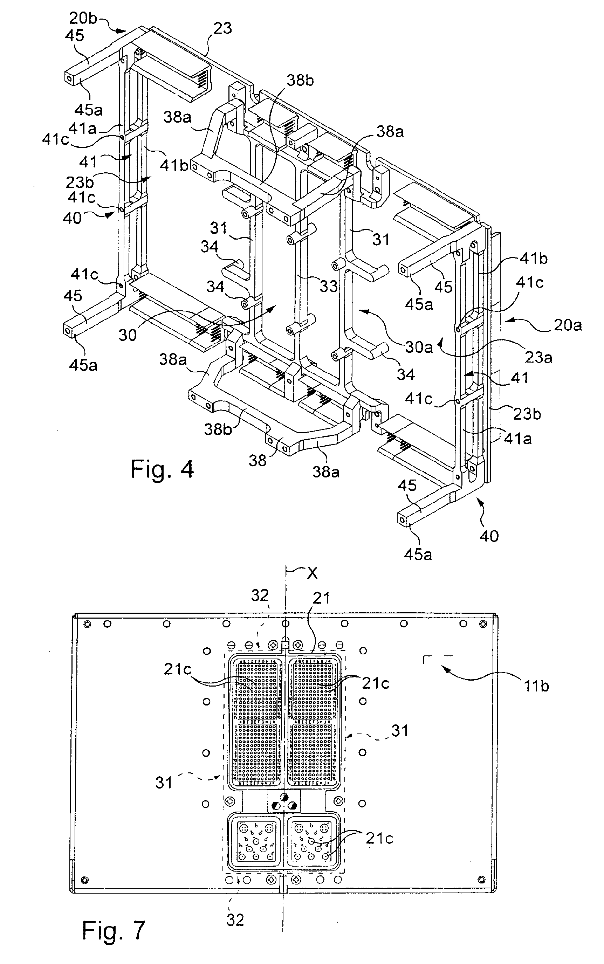

Comme bien illustré aux figures 2 et 7, les différents contacts 21 c du connecteur d'interface 21, de formes et de tailles variés, sont disposés dans la seconde face 21 b, sensiblement symétriquement par rapport à un axe central longitudinal X du connecteur d'interface 21.

Cet axe central longitudinal X correspond sur les figures à un axe vertical, s'étendant parallèlement au fond 11 b du socle 11 et perpendiculairement à la base 11a du socle 11.

Dans ce mode de réalisation, le connecteur d'interface 21 est en outre positionné sensiblement au centre du fond 11 b du socle 11 de l'équipement électronique 10.

Par ailleurs, comme bien illustré à la figure 3, la carte électronique de fond de panier 20 comporte, outre la première carte d'interface 22 mentionnée précédemment, une seconde carte d'interface 23, les deux cartes d'interface 22, 23 étant connectées l'une à l'autre.

Alors que la première carte d'interface 22 est reliée au connecteur d'interface 21, la seconde carte d'interface 23 est destinée à la connexion de l'ensemble des cartes électroniques (non représentées) de l'équipement électronique 10.

Comme bien illustré à la figure 3, cette seconde carte d'interface 23 comporte ainsi un ensemble de rainures 23' destinées au montage vertical des cartes électroniques de l'équipement électronique 10, destinées à être reliées mécaniquement et électroniquement à la seconde carte d'interface 23.

Comme bien illustré aux figures 3 et 4, la carte électronique de fond de panier 20 comporte des moyens de renfort 30, 40 montés entre les deux cartes d'interface 22, 23.

De manière générale, des premiers moyens de renfort 30 sont disposés sensiblement au centre de la carte électronique de fond de panier 20, au niveau du connecteur d'interface 21.

Des seconds moyens de renfort 40 sont disposés au niveau de deux bords libres en vis-à-vis des deux cartes d'interface 22, 23.

Comme bien illustré à la figure 4, les moyens de renfort 30, 40 comprennent notamment des raidisseurs 31, 41 qui s'étendent selon un axe longitudinal parallèle au plan des deux cartes d'interface 22, 23.

Dans ce mode de réalisation, ces raidisseurs 31, 41 s'étendent également parallèlement à l'axe central longitudinal X du connecteur central 21 tel que décrit précédemment à la figure 7.

Ainsi, les raidisseurs 31, 41 s'étendent dans le plan des deux cartes d'interface 22, 23 et sont perpendiculaires à la base 11 a du socle 11 de l'équipement électronique.

Ces raidisseurs 31, 41 forment ainsi de manière générale des entretoises entre deux faces 22a, 23a disposées en vis-à-vis des deux cartes d'interface 22, 23.

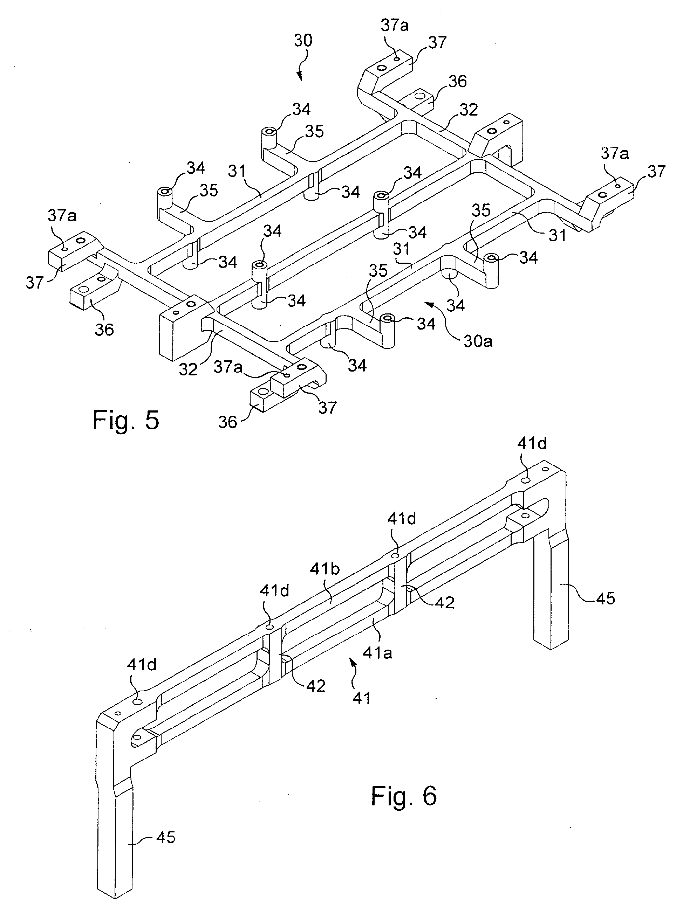

On va décrire à présent plus en détail en référence aux figures 4 et 5 les premiers moyens de renfort 30 destinés à être disposés sensiblement autour du connecteur d'interface 21 de la carte électronique de fond de panier 20.

De manière générale, ces premiers moyens de renfort 30 comprennent un cadre 30a comprenant deux raidisseurs longitudinaux 31 reliés par des barreaux transversaux 32 formant ainsi un cadre 30a sensiblement rectangulaire.

Comme schématisé à la figure 7, ce cadre 30a est disposé à la périphérie du connecteur d'interface 21.

Par ailleurs, dans ce mode de réalisation, les premiers moyens de renfort 30 comprennent également un bras 33 s'étendant dans le cadre 30a, parallèlement aux raidisseurs longitudinaux 31, entre les deux barreaux transversaux 32 du cadre 30a.

Ce bras 33 est disposé au centre du cadre 30a de telle sorte qu'il est disposé en vis-à-vis de l'axe central longitudinal X du connecteur d'interface 21 lorsque les premiers moyens de renfort 30 sont montés en vis-à-vis du connecteur d'interface 21.

Comme bien illustré à la figure 4, le cadre 30a des premiers moyens de renfort 30 est disposé entre les deux cartes d'interface 22, 23 et comprend une série de plots de fixation 34 montés en contact avec l'une ou l'autre des deux cartes d'interface 22, 23. Les plots de fixation 34 sont dirigés ainsi d'un côté ou de l'autre du plan formé par le cadre 30a.

Des plots de fixation 34 sont montés directement sur les raidisseurs longitudinaux 31 ou le bras 33 de manière à venir en contact avec l'une ou l'autre des deux faces 22a, 23a disposées en vis-à-vis des deux cartes d'interface 22, 23.

Le cadre 30a comporte également, au niveau des raidisseurs longitudinaux 31, des ailes de fixation 35 s'étendant perpendiculairement aux raidisseurs longitudinaux 31 et dans le plan du cadre 30a pour le montage déporté d'un certain nombre de plots de fixation 34, permettant ainsi une meilleure répartition des points de fixation des premiers moyens de renfort 30 sur les deux cartes d'interface 22, 23.

Les premiers moyens de renfort 30 comportent également une première série de pattes de fixation 36 s'étendant au-delà du cadre 30a à partir des barreaux transversaux 32 et perpendiculairement à ces barreaux transversaux 32. Elles sont destinées au montage des premiers moyens de renfort 30 sur la face 23a de la seconde carte d'interface 23.

Les premiers moyens de renfort 30 comportent en outre dans ce mode de réalisation une seconde série de pattes de fixation 37 s'étendant également au-delà du cadre 30a, sensiblement perpendiculairement aux barreaux transversaux 32.

Ces secondes pattes de fixation 37 sont destinées tout d'abord à la fixation des premiers moyens de renfort 30 à la face 22a de la première carte d'interface 22.

Ces pattes de fixation 37 de la seconde série comportent également des points de fixation 37a permettant le montage de premiers pieds de fixation 38 destinés à être montés à l'opposé sur le socle 11 de l'équipement électronique, et plus précisément sur le fond 11 b du socle 11.

Dans ce mode de réalisation, comme bien illustré à la figure 4, les premiers pieds de fixation 38 sont au nombre de deux, montés respectivement aux deux extrémités transversales des premiers moyens de renfort 30, au niveau des pattes de fixation 37 montées sur les bords transversaux 32 du cadre 30a.

Chaque pied de fixation 38 comporte plus précisément deux bras coudés 38a fixés à une première extrémité aux pattes de fixation 37 des premiers moyens de renfort 30 et à une seconde extrémité, à une tige de liaison 38b destinée à être montée par fixation sur le fond 11 b du socle 11 de l'équipement électronique 10.

Ces pieds de fixation 38 permettent ainsi de reprendre au niveau du socle 11 les efforts et les vibrations transmises par les cartes d'interface 22, 23 au niveau du connecteur d'interface 21.

On va décrire à présent en référence aux figures 4 et 6 les seconds moyens de renfort 40.

Les seconds moyens de renfort 41 comportent deux structures identiques montées respectivement entre deux bords libres 22b, 23b des deux cartes d'interface 22, 23.

On va décrire à présent en référence à la figure 6 l'une des structures des seconds moyens de renfort 41, l'autre structure étant identique.

Chaque raidisseur 41 des seconds moyens de renfort 40 est ainsi constitué d'un barreau 41 qui est destiné à s'étendre parallèlement aux bords libres 22b, 23b des deux cartes d'interface 22, 23.

Chaque barreau 41 s'étend ainsi parallèlement à chaque bord transversal 20a, 20b de la carte électronique de fond de panier 20, parallèlement à l'axe central longitudinal X décrit précédemment.

Dans ce mode de réalisation, et de manière non limitative, chaque barreau 41 comprend deux montants 41 a, 41 b reliés par des entretoises 42.

Ici, chaque barreau 41 forme ainsi une structure en échelle avec deux entretoises 42 reliant les deux montants 41 a, 41 b. Les entretoises sont équiréparties dans la longueur des montants 41 a, 41b.

Cette structure particulière permet d'alléger le barreau 41 tout en conservant une rigidité au barreau 41.

Comme bien illustré aux figures 4 et 6, un premier montant 41a du barreau 41 est destiné à être fixé en différents points de fixation 41 c à la face 22a de la première carte d'interface 22, alors que le deuxième montant 41 b du barreau 41 est destiné à être fixé en différents points de fixation 41 d à la face 23a de la seconde carte d'interface 23.

Par ailleurs, dans ce mode de réalisation, chaque barreau 41 est prolongé à ces extrémités par deux pieds de fixation 45 s'étendant perpendiculairement au barreau 41.

Comme bien illustré à la figure 4, ces pieds de fixation 45 sont destinés à s'étendre perpendiculairement au plan des deux cartes d'interface 22,23.

Ces pieds de fixation 45 comportent à leur extrémité libre 45a des moyens de fixation adaptés à coopérer avec le fond 11 b du socle 11 de l'équipement électronique 10.

Ainsi, comme bien illustré à la figure 1, chaque pied 45 des seconds moyens de renfort 40 est fixé aux angles du fond 11 b du socle 11 de l'équipement électronique, permettant ainsi une reprise des efforts appliqués sur les seconds moyens de renfort 40.

La carte électronique de fond de panier 20 telle que décrite précédemment présente ainsi une meilleure résistance à la fatigue mécanique liée aux vibrations.

En particulier, les premiers moyens de renfort 30 permettent de limiter les déplacements relatifs des contacts au niveau du connecteur d'interface 21 grâce à la rigidité apportée par le cadre 30a et le bras 33 des premiers moyens de renfort 30.

Les seconds moyens de renfort 40 permettent notamment de limiter la flexion des cartes d'interface 22, 23 au niveau de leurs bords libres 22b, 23b au niveau des bords transversaux 20a, 20b de la carte électronique de fond de panier 20.

De manière générale, l'atténuation des déformations est obtenue grâce à ces moyens de renfort 30, 40 qui permettent d'augmenter la fréquence des modes propres afin de diminuer les déplacements relatifs des cartes d'interface 22, 23 et ainsi protéger les composants montés sur ces cartes.

Grâce au montage de ces moyens de renfort 30, 40 entre les cartes d'interface 22, 23 de la carte électronique de fond de panier 20, l'encombrement d'ensemble n'est pas modifié.

De préférence, les moyens de renfort 30, 40 sont réalisés en aluminium présentant l'avantage d'être peu coûteux et surtout de faible poids, notamment dans les applications avioniques.

A titre d'exemple non limitatif, pour une carte électronique de fond de panier classique d'un équipement avionique, la masse ajoutée, de l'ordre de 120 g, par les premiers moyens de renfort 30, 40 tels que décrits précédemment, représente environ 0,8% de la masse totale de l'équipement électronique, et est ainsi négligeable.

Le montage des moyens de renfort 30, 40 peut être réalisé facilement en même temps que le montage de la carte électronique de fond de panier 20, notamment lors du montage des deux cartes d'interface 22, 23 avec le connecteur d'interface 21.

L'ensemble des fixations peut être réalisé par tout moyen connu, et notamment par vissage dans les différents points de fixation prévus à cet effet dans les moyens de renfort 30, 40.

Bien entendu, la présente invention n'est pas limitée à l'exemple de réalisation décrit précédemment.

En particulier, la carte électronique de fond de panier pourrait ne comporter que les premiers moyens de renfort 30, au niveau du connecteur d'interface 21, ou encore que les seconds moyens de renfort 40 disposés au niveau des bords transversaux 20a, 20b de la carte électronique de fond de panier 20.

## Revendications

1. Carte électronique de fond de panier d'un équipement électronique (10) embarqué, comportant un connecteur d'interface (21) avec un système externe et deux cartes d'interface (22, 23) connectées l'une à l'autre, une première carte d'interface (22) étant reliée audit connecteur d'interface (21) et une seconde carte d'interface (23) étant destinée à la connexion d'un ensemble de cartes électroniques dudit équipement électronique (10), ladite carte électronique de fond de panier (20) comportant des moyens de renfort (30, 40) montés entre lesdites deux cartes d'interface (22, 23), **caractérisée en ce que** lesdits moyens de renfort (30, 40) comprennent des raidisseurs (31, 33, 41) s'étendant selon un axe longitudinal (X) parallèle au plan desdites deux cartes d'interface (22, 23) et formant entretoise entre deux faces (22a, 23a) disposées en vis-à-vis desdites deux cartes d'interface (22, 23).

2. Carte électronique de fond de panier conforme à la revendication 1, **caractérisée en ce que** lesdits moyens de renfort comprennent des premiers moyens de renfort (30) comprenant un cadre (30a) disposé en vis-à-vis de la périphérie dudit connecteur d'interface (21).

3. Carte électronique de fond de panier conforme à la revendication 2, ledit connecteur d'interface (21) comprenant une face (21 b) munie de contacts (21 c) destinés à relier ledit connecteur d'interface (21) à ladite première carte d'interface (22), lesdits contacts (21 c) étant répartis sensiblement symétriquement par rapport à un axe central longitudinal (X) dudit connecteur d'interface (21), **caractérisée en ce que** lesdits premiers moyens de renfort (30) comprennent en outre un bras (34) de renfort s'étendant entre deux barreaux transversaux (32) dudit cadre (30a), en vis-à-vis de l'axe central longitudinal (X) dudit connecteur d'interface (21).

4. Carte électronique de fond de panier conforme à l'une des revendications 2 ou 3, **caractérisée en ce que** ledit cadre (30a) desdits premiers moyens de renfort (30) est disposé entre lesdites deux cartes d'interface (22, 23) et comprend une série de plots de fixation (34) montés en contact avec l'une ou l'autre desdites deux cartes d'interface (22, 23).

5. Carte électronique de fond de panier conforme à l'une des revendications 1 à 4, **caractérisée en ce que** lesdits moyens de renfort comprennent des seconds moyens de renfort (40) disposés entre deux bords libres (22b, 23b) en vis-à-vis desdites deux cartes d'interface (22, 23).

6. Carte électronique de fond de panier conforme à la revendication 5, **caractérisée en ce que** lesdits seconds moyens de renfort (40) comportent, à chaque bord transversal (20a, 20b) de ladite carte électronique de fond de panier (20), un barreau (41) s'étendant parallèlement auxdits bords libres (22b, 23b) desdites deux cartes d'interface (22, 23), chaque barreau (41) comprenant deux montants (41 a, 41 b) reliés par des entretoises (42).

7. Equipement électronique embarqué, notamment équipement avionique, comprenant une carte électronique de fond de panier (20) conforme à l'une des revendications 1 à 6.

8. Equipement électronique embarqué conforme à la revendication 7, **caractérisé en ce que** ladite carte électronique de fond de panier (20) est montée dans un socle (11) dudit équipement électronique embarqué (10), lesdits moyens de renfort (30, 40) comprenant des pieds de fixation (38, 45) montés sur ledit socle (11) dudit équipement électronique (10).

9. Aéronef, comprenant un ou plusieurs équipements électroniques embarqués (10) conforme à l'une des revendications 7 ou 8.

## Patentansprüche

1. Elektronische Karte für eine Rückwandplatine eines elektronischen Bordgeräts (10), umfassend einen Schnittstellenverbinder (21) mit einem externen System und zwei Schnittstellenkarten (22, 23), die miteinander verbunden sind, wobei eine erste Schnittstellenkarte (22) mit dem Schnittstellenverbinder (21) verbunden ist und eine zweite Schnittstellenkarte (23) für die Verbindung einer Gruppe von elektronischen Karten des elektronischen Geräts (10) bestimmt ist, wobei die elektronische Karte (20) für eine Rückwandplatine Verstärkungsmittel (30, 40) aufweist, die zwischen den beiden Schnittstellenkarten (22, 23) angebracht sind, **dadurch gekennzeichnet, dass** die Verstärkungsmittel (30, 40) Versteifungen (31, 33, 41) enthalten, die sich entlang einer Längsachse (X) parallel zur Ebene der beiden Schnittstellenkarten (22, 23) erstrecken und eine Verstrebung zwischen zwei Flächen (22a, 23a) bilden, die den beiden Schnittstellenkarten (22, 23) gegenüberliegend angeordnet sind.

2. Elektronische Karte für eine Rückwandplatine nach Anspruch 1, **dadurch gekennzeichnet, dass** die Verstärkungsmittel erste Verstärkungsmittel (30) mit einem Rahmen (30a) umfassen, der dem Umfang des Schnittstellenverbinders (21) gegenüberliegend angeordnet ist.

3. Elektronische Karte für eine Rückwandplatine nach Anspruch 2, **dadurch gekennzeichnet, dass** der Schnittstellenverbinder (21) eine Fläche (21 b) aufweist, die mit Kontakten (21 c) ausgestattet ist, die dazu bestimmt sind, den Schnittstellenverbinder (21) mit der ersten Schnittstellenkarte (22) zu verbinden, wobei die Kontakte (21 c) im Wesentlichen symmetrisch bezüglich einer Mittellängsachse (X) des Schnittstellenverbinders (21) verteilt sind, **dadurch gekennzeichnet, dass** die ersten Verstärkungsmittel (30) zudem einen Verstärkungsarm (34) umfassen, der sich zwischen zwei Querstäben (32) des Rahmens (30a) entgegengesetzt zur Mittellängsachse (X) des Schnittstellenverbinders (21) erstreckt.

4. Elektronische Karte für eine Rückwandplatine nach einem der Ansprüche 2 oder 3, **dadurch gekennzeichnet, dass** der Rahmen (30a) der ersten Verstärkungsmittel (30) zwischen den beiden Schnittstellenkarten (22, 23) angeordnet ist und eine Reihe von Befestigungszapfen (34) aufweist, die in Kontakt mit der einen oder anderen der beiden Schnittstellenkarten (22, 23) angebracht sind.

5. Elektronische Karte für eine Rückwandplatine nach einem der Ansprüche 1 bis 4, **dadurch gekennzeichnet, dass** die Verstärkungsmittel zweite Verstärkungsmittel (40) umfassen, die zwischen zwei gegenüberliegenden freien Rändern (22b, 23b) der beiden Schnittstellenkarten (22, 23) angeordnet sind.

6. Elektronische Karte für eine Rückwandplatine nach Anspruch 5, **dadurch gekennzeichnet, dass** die zweiten Verstärkungsmittel (40) an jedem quer verlaufenden Rand (20a, 20b) der elektronischen Karte (20) für eine Rückwandplatine einen Stab (41) umfassen, der sich parallel zu den freien Rändern (22b, 23b) der beiden Schnittstellenkarten (22, 23) erstreckt, wobei jeder Stab (41) zwei Stützen (41 a, 41 b) aufweist, die über Streben (42) miteinander verbunden sind.

7. Elektronisches Bordgerät, insbesondere luftfahrttechnisches Gerät, der eine elektronische Karte (20) für eine Rückwandplatine nach einem der Ansprüche 1 bis 6 umfasst.

8. Elektronisches Bordgerät nach Anspruch 7, **dadurch gekennzeichnet, dass** die elektronische Karte (20) für eine Rückwandplatine in einem Sockel (11) des elektronischen Bordgeräts (10) angebracht ist, wobei die Verstärkungsmittel (30, 40) Befestigungsfüße (38, 45) aufweisen, die an dem Sockel (11) des elektronischen Bordgeräts (10) angebracht sind.

9. Luftfahrzeug, das eine oder mehrere elektronische Bordgeräte (10) nach einem der Ansprüche 7 oder 8 umfasst.

## Claims

1. Backplane electronic circuit board of an on-board electronic apparatus (10), comprising an interface connector (21) with an external system and two interface boards (22, 23) connected to one another, a first interface board (22) being connected to the said interface connector (21) and a second interface board (23) being intended for the connection of a set of electronic circuit boards of the said electronic apparatus (10), the said backplane electronic circuit board (20) comprising reinforcement means (30, 40) installed between the said two interface boards (22, 23), **characterized in that** the said reinforcement means (30, 40) comprise stiffeners (31, 33, 41) extending along a longitudinal axis (X) parallel to the plane of the said two interface boards (22, 23) and forming a crosspiece between two faces (22a, 23a) arranged opposite each other of the said two interface boards (22, 23).

2. Backplane electronic circuit board in accordance with claim 1, **characterized in that** the said reinforcement means comprise first reinforcement means (30) comprising a frame (30a) arranged opposite the periphery of the said interface connector (21).

3. Backplane electronic circuit board in accordance with claim 2, the said interface connector (21) comprising a face (21b) equipped with contacts (21c) intended to connect the said interface connector (21) to the said first interface board (22), the said contacts (21c) being distributed more or less symmetrically in relation to a central longitudinal axis (X) of the said interface connector (21), **characterized in that** the said first reinforcement means (30) further comprise a reinforcement arm (34) extending between two crossbars (32) of the said frame (30a), opposite the central longitudinal axis (X) of the said interface connector (21).

4. Backplane electronic circuit board in accordance with one of claims 2 or 3, **characterized in that** the said frame (30a) of the said first reinforcement means (30) is arranged between the said two interface boards (22, 23) and comprises a series of fastening studs (34) installed in contact with one or the other of the said two interface boards (22, 23).

5. Backplane electronic circuit board in accordance with one of claims 1 to 4, **characterized in that** the said reinforcement means comprise second reinforcement means (40) arranged between two free edges (22b, 23b) opposite each other of the said two interface boards (22, 23).

6. Backplane electronic circuit board in accordance with claim 5, **characterized in that** the said second reinforcement means (40) comprise, at each transverse edge (20a, 20b) of the said backplane electronic circuit board (20), a bar (41) extending parallel to the said free edges (22b, 23b) of the said two interface boards (22, 23), each bar (41) comprising two uprights (41a, 41b) connected by crosspieces (42).

7. On-board electronic apparatus, in particular an avionic apparatus, comprising a backplane electronic circuit board (20) in accordance with one of claims 1 to 6.

8. On-board electronic apparatus in accordance with claim 7, **characterized in that** the said backplane electronic circuit board (20) is installed in a stand (11) of the said on-board electronic apparatus (10), the said reinforcement means (30, 40) comprising fastening feet (38, 45) installed on the said stand (11) of the said electronic apparatus (10).

9. Aircraft, comprising one or more on-board electronic apparatuses (10) in accordance with one of claims 7 or 8.
